**Europäisches Patentamt**

**(19) European Patent Office**

**Office européen des brevets**

(11) Publication number : **0 400 751 B1**

## (12) EUROPEAN PATENT SPECIFICATION

(45) Date of publication of patent specification :
27.12.95 Bulletin 95/52

(21) Application number : 90201365.5

(22) Date of filing : 29.05.90

(51) Int. Cl.⁶ : **H01J 29/48, H01J 3/02**

(54) Electric discharge element

(30) Priority : 01.06.89 NL 8901390

(43) Date of publication of application :
05.12.90 Bulletin 90/49

(45) Publication of the grant of the patent :
27.12.95 Bulletin 95/52

(84) Designated Contracting States :
DE ES FR GB IT NL

(56) References cited :
US-A- 4 069 439
PATENT ABSTRACTS OF JAPAN, vol. 12, no.
412 (E-676)(3259), 31st October 1988 & JP-A-63
150 835
The Microchannel Image Intensifier, Scientific
American, vol. 245 (1981), Nov., No. 5, New
York, USA

(73) Proprietor : Philips Electronics N.V.
Groenewoudseweg 1
NL-5621 BA Eindhoven (NL)

(72) Inventor : van Gorkom, Gerardus Gegorius
Petrus
c/o INT. OCTROOIBUREAU B.V.,
Prof. Holstlaan 6
NL-5656 AA Eindhoven (NL)

(74) Representative : Koppen, Jan et al
INTERNATIONAAL OCTROOIBUREAU B.V.,
Prof. Holstlaan 6
NL-5656 AA Eindhoven (NL)

Note : Within nine months from the publication of the mention of the grant of the European patent, any
person may give notice to the European Patent Office of opposition to the European patent granted.
Notice of opposition shall be filed in a written reasoned statement. It shall not be deemed to have been
filed until the opposition fee has been paid (Art. 99(1) European patent convention).

## Description

The invention relates to an electric discharge element comprising an electron source having an electron emitting surface, which electron source cooperates with at least one vacuum electron duct. The invention relates also to an electron beam addressing system based on such discharge elements. Conventional electric discharge elements such as, for example electron tubes do not have facilities of guiding electron beams in a localized way. Moreover, they have the limitation that their electron sources produce electron currents with a limited current density. For a number of applications it would be very interesting if electric discharge elements were available with facilities of guiding electron beams in a localized way or of supplying electron currents with a larger current density. Such applications are, for example (TV) display tubes, electron microscopes, electron beam lithography devices.

It is an object of the invention to comply with this wish. According to the invention such an electric discharge element is therefore characterized by the features of claim 1.

Based on the same idea it is also possible to make an electron beam addressing system according to claim 14. The dependent claims describe particular embodiments of the invention.

The invention is based on the recognition that electron transport through cavities defined by walls of electrically insulating material (for example glass, ceramic material, kapton, pertinax etc.) is possible, provided that a sufficiently strong electric field is applied in the longitudinal direction of the cavity. The value of this field depends on the type of material and on the geometry and the sizes of the cavity walls. The electron transport then takes place via a secondary emission process so that for each electron impinging on a cavity wall one electron is emitted on an average.

The circumstances can thus be chosen to be such that substantially as many electrons enter the cavity as leave at the output again. A very advantageous vacuum electron duct can thus be realised.

It is noted that from US-A-4.069.139 a flat panel display is known per se in which separate electron beams are injected into a number of adjacent electron guides. However contrary to the present invention, in the known device the electron beams propagate through the guides without any substantial interaction with the walls of the guides. Such interaction is even counteracted. Consequently no special demands are imposed on the material of the walls of the electron guides.

Moreover it is noted from Scientific American Vol. 245 Nov. 1981, No. 5, page 46-55 a continuous channel electron multiplier is known per se which comprises a glass tube connected at each end to a source of electric power and is placed in a vacuum. However contrary to the device of the invention this known device has tube walls which have a conductivity sufficient to satisfactorily replenish any charge removed from the wall in order to achieve an effective multiplication factor considerably larger than one.

The discharge element according to the invention may have a very simple construction if the cathode is located within the cavity of the electron duct. An interesting aspect of the latter embodiment is that if the output aperture has a surface $S_{out}$ which is smaller than the emissive surface $S_{cath}$ of the cathode, the current density of the electron current leaving the output aperture is a factor of $\dfrac{S_{cath}}{S_{out}}$ larger than the current density of the cathode.

Alternatively, the cathode may be located outside the cavity of the electron duct and the cavity may have an input aperture facing the cathode. In a practical embodiment the emissive cathode surface and the surface of the input aperture are substantially equal.

To enable electron transport over a certain distance, it is practicable if the cavity has an elongate shape. This means that the electron duct may be a straight or bent pipe. In one embodiment the electrons from a cathode with an emissive surface $S_{cath}$ are injected into the duct on one side. The input surface is $S_{in}$. Elsewhere in the duct there is an output aperture having a surface $S_{out}$. An electrically conducting electrode is provided on the outer side adjacent this aperture. The voltage difference $\Delta V$ between this electrode and the cathode provides the electric field required for the transport. Since the walls (substantially) cannot take up or supply any current, substantially as many electrons will enter the duct as will leave the output. For the current density $J_{out}$ at the output it then holds (if $J_{in}$ represents the current density at the input):

$$J_{out} = \frac{S_{cath}}{S_{out}} J_{in} \quad (1)$$

If $S_{cath} >> S_{out}$, a large gain in current density is possible, in other words a discharge element can be realised in this way which can supply current with a large current density.

A further embodiment is characterized in that the cathode has means for modulating the electron current to be emitted. By modulating at a location where the current density is small, the modulation can be effected with a smaller voltage sweep than is possible in comparable conventional discharge tubes (with, for example a triode).

Some embodiments illustrating the foregoing and further aspects of the invention will now be described in greater detail with reference to the accompanying drawings in which

Fig. 1 is a diagrammatic cross-section of a part of an electric discharge element with a cathode and an electron duct according to the invention;

Fig. 2 is a side elevation of the construction of Fig. 1;

Fig. 3 is a diagrammatic cross-section of an electric discharge tube with a cathode and an alternative electron duct;

Fig. 4 illustrates the operation of an electron duct;

Fig. 5 shows an alternative embodiment of an electron duct;

Fig. 6 shows a plurality of electron ducts with a common cathode;

Fig. 7 shows a cathode which cooperates with an electron duct having a plurality of output aperture which can be electrically driven;

Fig. 8 shows an arrangement of a plurality of electron ducts cooperating with cathodes which can be separately driven;

Fig. 9 shows diagrammatically an electron microscope comprising an electric discharge element according to the invention;

Fig. 10 shows a cathode ray tube with an electric discharge element according to the invention;

Figs. 11A, B and C show aspects of an electron beam addressing system; and

Fig. 12 is a graph in which the secondary emission coefficient $\delta$ is plotted as a function of the primary electron energy $E_p$ of a material suitable for the element according to the invention.

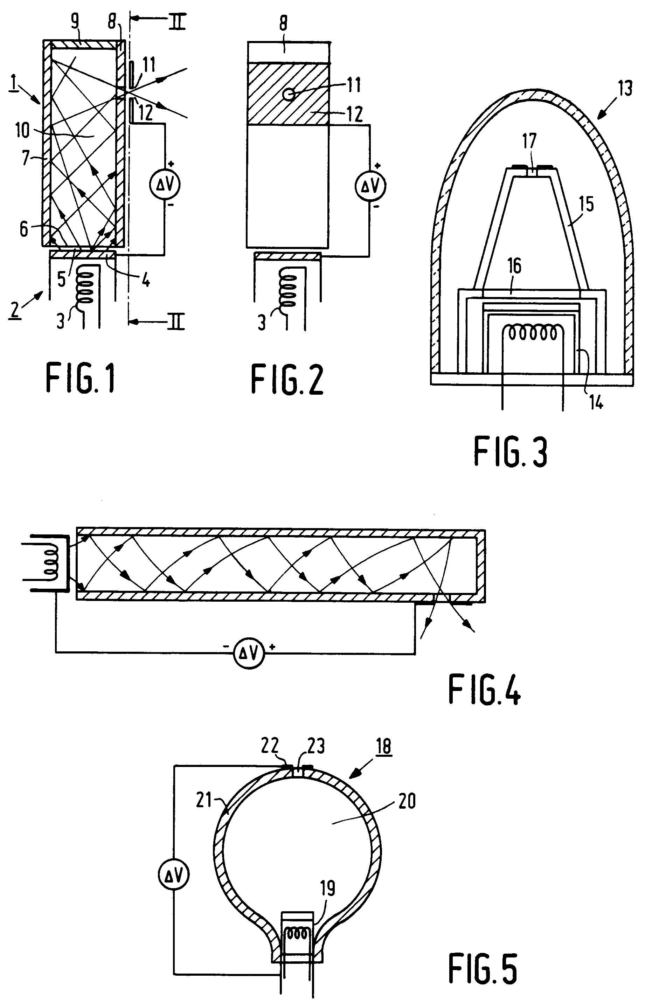

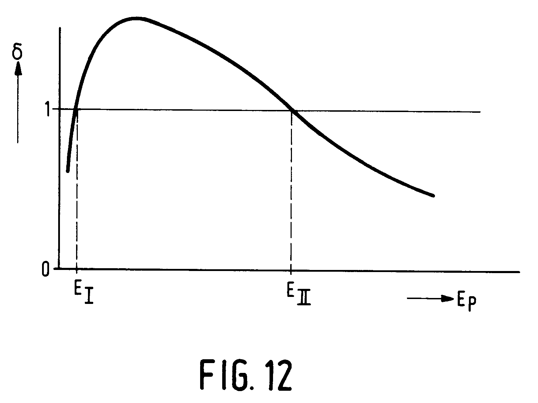

Fig. 1 is a diagrammatic cross-section of a part of an electric discharge element 1 comprising a cathode 2 having a filament 3 and an emitting layer 5 supported by a base 4. The emitting layer 5 has a surface $S_{cath}$ with which it faces an input aperture 6 having a surface $S_{in}$ of an elongate cavity 10 of an electron duct surrounded by walls 7, 8, 9 of electrically insulating material. This material must have a relatively high resistance (the higher the resistance, the less power is required) and a secondary emission coefficient $\delta > 1$ (see Fig. 12) over at least a certain range $E_I$-$E_{II}$ of primary electron energies $E_p$. Preferably, $E_I$ is as low as possible, for example one or several times 10 eV. Inter alia , glass ($E_I$ is approximately 30 eV), ceramic material, pertinax, kapton meet this requirement. One of the walls (in this case wall 8) has an output aperture 11 with a surface $S_{out}$. An electrode 12 adjoins the aperture 11 (see also Fig. 2). A voltage difference $\Delta V$ is applied between the electrode 12 and the cathode 2 for generating an electric field in the longitudinal direction of the cavity 10. If this field has a sufficiently large strength (which also depends on the material of the walls and on the dimensioning of the cavity 10), electron transport through the (evacuated) cavity is possible. The electron transport is effected via a process of secondary emission in which for each electron impinging upon a wall one electron is emitted on an average (Fig. 4). Substantially as many electrons injected into the cavity 10 at the input surface 6 leave the output aperture 11 because the electrically insulating walls have such a high resistance that they cannot produce or release any electrons at a substantial rate.

The construction shown in Fig. 1 thus represents a very advantageous device for transporting a localized electron current which can be used in many ways (a so-called electron fibre).

By rendering $S_{out} \ll S_{cath}$, the current density $J_{out}$ at the output 11 will be higher than the current density $J_{in}$ supplied by the cathode 2 so that an electron compressor is obtained which can be used in many ways.

However, for certain uses the luminosity parameter B which is proportional to $J/\Delta E$, in which $\Delta E$ is energy spread of the electrons, is important. It holds for the luminosity $B_{out}$ at the output (if $B_{in}$ is the luminosity at the input):

$$B_{out} = \frac{S_{in}}{S_{out}} \cdot \frac{(\Delta E)_{in}}{(\Delta E)_{out}} \cdot B_{in}.$$

For most thermal cathodes in a triode configuration it holds that $\Delta E$ is approximately equal to 0.2 eV at low currents, while $\Delta E$ may increase to approximately 2 eV at currents of the order of mAs. The energy spread of the electrons leaving the output aperture 11 $(\Delta E)_{out}$ is approximately 4 eV in a given case. The ratio $(\Delta E)_{in}/(\Delta E)_{out}$ is in this case in the range between approximately 1/2 and 1/20. Consequently, if $S_{in}/S_{out} > 2$ to 20, $B_{out} > B_{in}$.

Electron ducts with $S_{in}/S_{out} = 200$ have already been realised within the scope of the invention, but much higher values are possible. A gain in luminosity of 100-500 can then be realised. This means that the electron compressor proposed is very interesting for use in, for example TV display tubes, projection TV tubes, electron microscopes, electron beam lithography devices.

In addition to electron ducts without amplification the invention also relates to electron ducts with amplification. In the latter case the walls should be capable of supplying current. To this end they may have, for example, layers of a sufficiently high secondary emission coefficient so that current amplification by means of electron multiplication is possible. However, a problem is that the layers hitherto known with a sufficiently high secondary emission coefficient have a relatively short lifetime. For certain uses this need not be a problem. In that case it holds for the current density at the output $J_{out}$:

$$J_{out} = \frac{S_{cath}}{S_{out}} \cdot M \cdot J_{in}$$

in which M is the current amplification by multiplication.

Analogously it holds for the luminosity at the output $B_{out}$:

$$B_{out} = \frac{S_{cath}}{S_{out}} \cdot \frac{(\Delta E)_{in}}{(\Delta E)_{out}} \cdot M \cdot B_{in}.$$

It is to be noted that the electric discharge element according to the invention already operates at a relatively poor vacuum (provided that the cathode at the input operates); that the electon current at the input of the tube can be modulated with a much lower voltage sweep than is common practice (for example approximately 20 V instead of approximately 150 V) and that the cathode may be both a thermal cathode and a cold cathode like a field emitter or a p-n emitter.

Fig. 3 shows an electric discharge tube 13 with a cathode 14 and electron duct cavity 15 of a different type than that of Fig. 1. The cavity 15 is tapered and has an output aperture 17 facing an input aperture 16.

Fig. 5 shows an electric discharge element 18 which can be constructed in a very simple way, in which a cathode 19 is arranged within an electron duct cavity 20. An output aperture 23 provided with an electrode 22 is present in an envelope wall 21 which is spherical in this case.

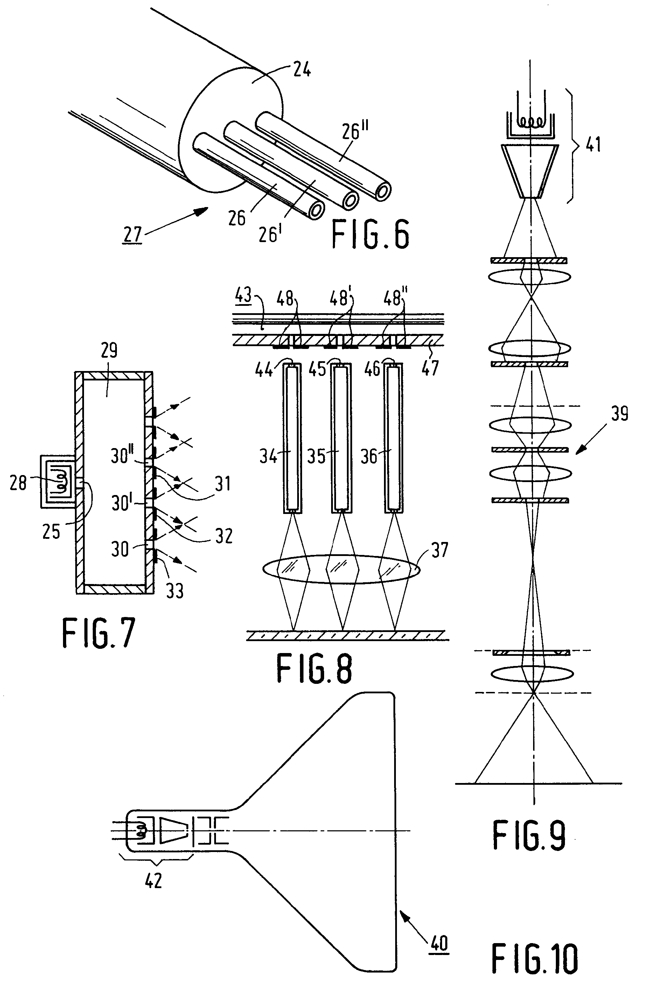

Fig. 6 shows an electron source 27 with a common cathode 24 which cooperates with a number (three in this case) of electron duct cavities 26, 26′, 26″. Such a construction may be used, for example as an electron source for a colour display tube in which the cavities 26, 26′, 26″ are successively brought to the electron transport mode (they are "driven") and the electron current emitted by the cathode 24 is modulated. An alternative is the use of a cathode 28 which cooperates with one electron duct cavity 29 which instead of one output aperture has a number (three in this case) of output apertures 30, 30′, 30″ which are provided with electrodes 31, 32, 33 so as to optionally "open" or "close" them electrically (Fig. 7).

An arrangement of straight or curved, tapered or non-tapered electron ducts 34, 35, 36 each cooperating with their own cathode or with a common cathode may be used, for example for producing a number of electron spots on a small surface. Fig. 8 shows an arrangement of electron ducts 34, 35, 36 used in combination with an electron-optical lens 37. In this case the electron ducts 34, 35, 36 have input apertures 44, 45, 46 which cooperate with a cathode configuration 43 comprising a line cathode 47 which provides for three electron emitters which can be separately driven by means of electrodes 48, 48′, 48″ which can be separately driven. This arrangement may be advantageously used in a device for electron beam lithography.

Fig. 9 shows diagrammatically an electron microscope 39 and Fig. 10 shows a (projection) display tube 40 with a discharge element 41 and 42 of the above-described "electron compression" type as an electron source. An electron source which can produce a large current density may be very advantageous for electron microscopes and (projection) display tubes.

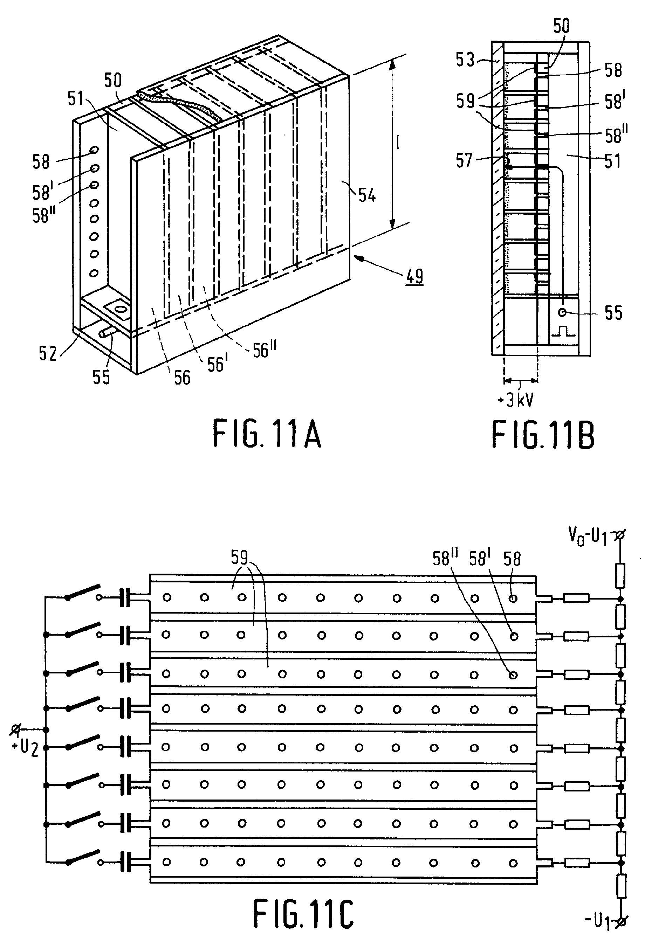

Figs. 11a, b and c are elevational views of an electron beam addressing system whose use in a display tube is described in greater detail in Patent Application EP-A-0 400 750 filed simultaneously.

A cathode arrangement, for example a line cathode 55 providing, for example 600 cathodes which can be separately driven is present proximate to the bottom of a wafer-shaped structure 49 with a rear wall 54. If necessary, a number of separate emitters, for example field emitters or p-n emitters may be used instead of a line cathode. Each of these emitters only needs to supply a current of pA or nA (dependent on the amplification) so that many types of (cold or thermal) cathodes are suitable. The emission of these cathodes can be modulated. A row of compartments 56, 56′, 56″, ... etc. with one compartment per cathode, is arranged just above the row 55 of cathodes. These compartments have walls which are made of, for example, ceramic material or lead glass, which has a suitable electrical resistance for the present object, and which have a secondary emission coefficient $\delta > 1$ over a given range of primary electron energies. The electrical resistance should be so large that a minimum possible amount of current (less than, for example 10 mA) will flow in the walls when a voltage difference required for vacuum electron transport is applied across the length 1 (which may be, for example, in the range of 1 to 1000 m) of the compartments. The resistance across the length of the cathode-sided sub-portion of the compartment may be lower (for example, of the order of 100 times lower) than across the remaining portion of the compartment so as to obtain some amplification of the cathode current, but preferably the resistance across the length of the cathode-sided sub portion is also high (particularly in the range of $10^6$-$10^{15\Omega}$) and all required current is drawn from the cathode so that transport without amplification occurs. One of the walls of each compartment may be constituted by the rear wall 54. In that case the rear wall is, for example, a flat substrate in a surface of which a plurality of parallel cavities is formed.

A voltage of the order of kVs is applied in the longitudinal direction 1 across all compartments combined. By applying a voltage of, for example 50 to 100 V between the row 55 of cathodes and the compartments 56, 56′, 56″, electrons are accelerated from the cathodes to the compartments so that they generate secondary electrons in the compartments. The required voltage is dependent on the circumstances, but will generally have to be more than 30 V. The generated secondary electrons are accelerated again and generate new electrons. This is continued until saturation. (This saturation may be space charge saturation and/or it may be produced by field distortion). From the saturation point, which may be reached very soon, a constant vacuum current will flow through the relevant compartment (compare Fig. 4). If the wall material is high-ohmic enough, the walls of the compartments cannot produce or take up any net current so that this current, even in a close approximation, is equal to the entering current. If the electric field is made larger than the minimum value which is required to obtain a state with $\delta_{eff} = 1$, the following will happen. As soon as $\delta$ is slightly larger than 1, the wall inhomogeneously is charged positively (due to the very small conductance this charge cannot be depleted). As a result the electrons will reach the wall earlier than in the absence of this positive charge, in other words: the average energy taken up from the electric field in the longitudinal direction will be smaller so that a state with an effective secondary emission coefficient $\delta_{eff} = 1$ adjusts itself. This is favourable aspect because the exact value of the field is not important as long as it is larger than the previously mentioned minimum value.

The compartment walls facing the rear wall 54 jointly constitute a "drive plate" 50 (see also Fig. 11B). This plate has apertures 58, 58′, 58″ ... etc. Furthermore there is a row of drive electrodes 59 on the outer side of the drive plate 50. These row electrodes 59 may be implemented in the way shown in Fig. 11C (electrodes "across" the apertures) or in the way shown in Fig. 11C and may be incorporated in an electric circuit with a resistance divider. In the off-state of a drive electrode 59 a voltage -U1 relative to the local compartment potential is applied, which voltage ensures that the electrodes cannot leave the compartment at that location. If a picture line must be switched on, an extra potential +U2 is applied. In view of the fact that the electrons in the compartments have a relatively low velocity due to the collisions with the walls, U1 and U2 may be comparatively low. In a certain case a value of 100 V for both U1 and U2 appeared to yield a good result.

Fig. 11B shows that electrons drawn by a drive electrode 59 from an electron guidance cavity 51 surrounded by compartment walls can be accelerated towards a target 57 so that one picture line at a time can thus be scanned.

It is to be noted that the structure 49 (see Fig. 11A), which constitutes, as it were, an electron beam addressing module, may be composed of separate components, for example a rear wall 54 with recesses and a front plate 50 with apertures, or it may alternatively be composed of one piece.

Furthermore it is to be noted that the walls which define the electron ducts may consist of an electrically insulating material which has a constructive function as well as a secondary emission function. Alternatively, they may consist of an electrically insulating material having a constructive function (for example, a synthetic material), on which material a layer having a secondary emission function is provided (for example, quartz or glass or ceramic material such as MgO).

## Claims

1. An electric discharge element (1) comprising an electron source (2) having an electron emitting surface ($S_{cath}$), which electron source (2) cooperates with at least one vacuum electron duct (10) **characterized in that** the vacuum electron duct comprises a cavity (10) defined by walls (7,8,9) of an electrically insulating material having a relatively high resistance and a secondary emission coefficient $\delta$ which, for a certain range of electron energies, is larger than one, and in that said cavity (10) has an output aperture (11), while electrode means (12) connectable to a voltage source are provided for applying, in operation, an electric field across a path in the cavity (10) from the electron source (2) to the output aperture (11) in order to enable electron transport through said cavity (10), which electron transport is effected via a process of secondary emission, in which for each electron impinging upon a wall one electron is emitted on an average.

2. A discharge element as claimed in Claim 1, characterized in that the electron source is located within the cavity.

3. A discharge element as claimed in Claim 1, characterized in that the electron source is located outside the cavity and in that the cavity has an input aperture facing the electron source.

4. A discharge element as claimed in Claim 1, 2 or 3, characterized in that the cavity has an elongate shape.

5. A discharge element as claimed in Claim 4, characterized in that the electron emitting surface and the surface of the input aperture are substantially equal.

6. A discharge element as claimed in Claim 1, 2 or 3, characterized in that the surface of the output aperture is smaller than the electron emitting surface.

7. A discharge element as claimed in Claim 6, characterized in that in operation the current density of an electron beam leaving the output aperture is larger than the current density of an electron beam emitted by the electron source.

8. A discharge element as claimed in Claim 6, characterized in that in operation the luminosity of an electron beam leaving the output aperture is larger than the luminosity of an electron beam emitted by the electron source.

9. A discharge element as claimed in Claim 1, characterized in that the electron source is provided with means for modulating the electron current to be emitted.

10. A discharge element as claimed in Claim 4, characterized in that at least one output aperture is provided in a longitudinally extending cavity wall.

11. A discharge element as claimed in Claim 8, characterized in that a series of adjoining output apertures is provided in a longitudinally extending cavity wall.

12. A discharge element as claimed in Claim 11, characterized in that electrodes are provided proximate to the output apertures, which electrodes can be connected to energizing means for energizing them in operation with a voltage required for electrically opening or closing the apertures.

13. A discharge element as claimed in Claim 12, characterized in that the energizing means are adapted to sequentially energize the output apertures.

14. An electron beam addressing system (49) **characterized by** a plurality of adjoining, elongate electron duct cavities (56,56′,56″) each cooperating with an electron source (55), while electrode means connectable to a voltage source are provided for applying, in operation, an electric field across a path in each cavity from the electron source to an output aperture in order to enable electron transport through said cavity, which cavities are defined by walls (50,51,54) of an electrically insulating material having a relatively high resistance and a secondary emission coefficient δ which, for a certain range of electron energies, is larger than one, while corresponding longitudinally extending cavity walls are provided with a series of apertures (58,58′,58″) which can be electrically driven and jointly constitute a matrix arrangement, which electron transport is effected via a process of secondary emission, in which for each electron impinging upon a wall one electron is emitted on an average.

15. An addressing system as claimed in Claim 14, characterized in that the electron sources and the apertures can be connected to drive means for realising, in operation, a line-sequential scanning of the matrix arrangement.

16. A camera tube comprising an electron beam addressing system as claimed in Claim 14 or 15.

17. A display tube comprising an electron beam addressing system as claimed in Claim 14 or 15.

18. An electron microscope comprising an electric discharge element as claimed in any one of Claims 1-10 as an electrode source.

19. An electric discharge element as claimed in claim 1 **characterized in that** said electron source (55) cooperates with a number of vacuum electron ducts (56,56′,56″) each being defined by walls (50,51,54) of an electrically insulating material having a relatively large resistance and a secondary emission coefficient δ which, for a certain range of electron energies, is larger than one, and each having an output aperture, while electrode means connectable to a voltage source are provided for applying, in operation, an electric field across a path in each duct from the electron source to the output aperture in order to enable electron transport through said duct.

20. A device for electron beam lithography comprising an electric discharge element as claimed in Claim 19 as an electron source.

21. A device as claimed in any one of the preceding Claims, characterised in that in operation the effective secondary emission coefficient $\delta_{eff}$ is approximately equal to 1.


**Patentansprüche**

1. Elektrisches Entladungselement (1) mit einer Elektronenquelle (2) mit einer Elektronenemissionsfläche ($S_{cath}$), wobei die Elektronenquelle (2) mit wenigstens einem vakuum Elektronenkanal (10) zusammenarbeitet, dadurch gekennzeichnet, daß der vakuum Elektronenkanal einen Hohlraum (10) enthält, der von Wänden (7, 8, 9) aus einem elektrisch isolierenden Material mit einem verhältnismäßig hohen Widerstandswert und mit einem Sekundäremissionskoeffizienten δ definiert wird, der für ein bestimmtes Gebiet von Elektronenenergien größer als eins ist, und daß der Hohlraum (10) eine Ausgangsapertur (11) enthält, während mit einer Spannungsquelle verbindbare Elektrodenmittel (12) zum Erzeugen eines elektrischen Feldes im Betrieb über einen Weg im Hohlraum (10) von der Elektronenquelle (2) nach der Ausgangsapertur (11) vorgesehen sind, um Elektronentransport durch den Hohlraum (10) zu ermöglichen, wobei der Elektronentransport mittels eines Sekundäremissionsvorgangs erfolgt, mit dem für jedes Elektron bei der Landung auf eine Wand ein Elektron im Mittel emittiert wird.

2. Entladungselement nach Anspruch 1, dadurch gekennzeichnet, daß die Elektronenquelle sich im Hohlraum befindet.

3. Entladungselement nach Anspruch 1, dadurch gekennzeichnet, daß die Elektronenquelle sich außerhalb des Hohlraums befindet, und daß der Hohlraum eine der Elektronenquelle zugewandte Eingangsapertur hat.

4. Entladungselement nach Anspruch 1, 2 oder 3, dadurch gekennzeichnet, daß der Hohlraum eine längliche Form hat.

5. Entladungselement nach Anspruch 4, dadurch gekennzeichnet, daß die Elektronenemissionsfläche und die Oberfläche der Eingangsapertur im wesentlichen gleich sind.

6. Entladungselement nach Anspruch 1, 2 oder 3, dadurch gekennzeichnet, daß die Oberfläche der Ausgangsapertur kleiner ist als die Elektronenemissionsfläche.

7. Entladungselement nach Anspruch 6, dadurch gekennzeichnet, daß im Betrieb die Stromdichte eines Elektronenbündels aus der Ausgangsapertur größer ist als die Stromdichte eines von der Elektronenquelle emittierten Elektronenbündels.

8. Entladungselement nach Anspruch 6, dadurch gekennzeichnet, daß im Betrieb die Helligkeit eines Elektronenbündels aus der Ausgangsapertur größer ist als die Helligkeit eines von der Elektronenquelle emittierten Elektronenbündels.

9. Entladungselement nach Anspruch 1, dadurch gekennzeichnet, daß die Elektronenquelle mit Mitteln zum Modulieren des zu emittierenden Elektronenstroms versehen ist.

10. Entladungselement nach Anspruch 4, dadurch gekennzeichnet, daß wenigstens eine Ausgangsapertur in einer in der Längsrichtung sich erstreckenden Hohlraumwand vorgesehen ist.

11. Entladungselement nach Anspruch 8, dadurch gekennzeichnet, daß eine Reihe benachbarter Ausgangsaperturen in einer sich in der Längsrichtung erstreckenden Hohlraumwand vorgesehen ist.

12. Entladungselement nach Anspruch 11, dadurch gekennzeichnet, daß Elektroden in der Nähe der Ausgangsaperturen angeordnet sind, und diese Elektroden können mit Erregermitteln zum Erregen der Elektroden im Betrieb mit einer erforderlichen Spannung zum elektrischen Öffnen oder Schließen der Aperturen verbunden werden.

13. Entladungselement nach Anspruch 12, dadurch gekennzeichnet, daß die Erregermittel zum sequentiellen Erregen der Ausgangsaperturen ausgelegt werden.

14. Elektronenbündeladressiersystem (49) gekennzeichnet durch eine Vielzahl benachbarter länglicher Elektronenkanalhohlräume (56, 56', 56″) die je mit einer Elektronenquelle (55) zusammenarbeiten, während mit einer Spannungsquelle verbindbare Elektrodenmittel zum Erzeugen eines elektrischen Felds im Betrieb über einen Weg in jedem Hohlraum von der Elektronenquelle nach einer Ausgangsapertur vorgesehen sind, um Elektronentransport durch den Hohlraum zu ermöglichen, wobei die Hohlräume durch Wände (50, 51, 54) aus einem elektrisch isolierenden Material mit einem verhältnismäßig hohen Widerstandswert und einem Sekundäremissionskoeffizienten δ definiert werden, der für einen bestimmten Bereich von Elektronenenergien größer als eins ist, während entsprechende sich in der Längsrichtung erstreckende Hohlraumwände mit einer Reihe von Aperturen (58, 58', 58″) versehen werden, die elektrisch steuerbar sind und zusammen eine Matrixanordnung bilden, wobei der Elektronentransport mittels eines Sekundäremissionsvorgangs erfolgt, mit dem für jedes Elektron bei der Landung auf eine Wand ein Elektron im Mittel emittiert wird.

15. Adressiersystem nach Anspruch 14, dadurch gekennzeichnet, daß die Elektronenquellen und die Aperturen mit Steuermitteln zum Verwirklichen einer zeilensequentiellen Abtastung der Matrixanordnung im Betrieb verbunden werden können.

16. Kameraröhre mit einem Elektronenbündeladressiersystem nach Anspruch 14 oder 15.

17. Bildwiedergaberöhre mit einem Elektronenbündeladressiersystem nach Anspruch 14 oder 15.

18. Elektronenmikroskop mit einem elektrischen Entladungselement nach einem der Ansprüche 1 bis 10 als Elektrodenquelle.

19. Elektrisches Entladungselement nach Anspruch 1, dadurch gekennzeichnet, daß die Elektronenquelle (55) mit einer Anzahl von vakuum Elektronenkanälen (56, 56', 56″) zusammenarbeitet, die je durch Wände (50, 51, 54) aus einem elektrisch isolierenden Material mit einem verhältnismäßig hohen Widerstandswert und einem Sekundäremissionskoeffizienten δ definiert werden, der für einen bestimmten Bereich der Elektronenenergien größer als eins ist, und je eine Ausgangsapertur haben, während mit einer Spannungsquelle verbindbare Elektrodenmittel zum Erzeugen eines elektrischen Feldes im Betrieb über einen Weg in jedem Kanal von der Elektro-nenquelle nach der Ausgangsapertur vorgese-hen sind, um Elektronentransport durch den Kanal zu ermöglichen.

20. Anordnung für Elektronenbündellithographie mit einem elektrischen Entladungselement nach Anspruch 19 als Elektronenquelle.

21. Anordnung nach einem oder mehreren der vorangehenden Ansprüche, dadurch gekennzeichnet, daß im Betrieb der wirksame Sekundäremissi-onskoeffizient $\delta_{eff}$ etwa gleich 1 ist.


**Revendications**

1. Elément à décharge électrique (1) comprenant une source d'électrons (2) ayant une surface ($S_{cath}$) émettant des électrons, laquelle source d'électrons (2) coopère avec au moins un conduit électronique à vide (10), caractérisé en ce que le conduit électronique à vide comprend une cavité (10) définie par des parois (7, 8, 9) en une matière isolante électrique ayant une résistance relativement élevée et un coefficient d'émission secon-daire $\delta$ qui, pour un certain domaine d'énergies électroniques, est supérieur à 1, et en ce que ladite cavité (10) a un orifice de sortie (11), alors que des moyens à électrode (12) connectables à une source de tension sont prévus pour appliquer, en fonctionnement, un champ électrique aux extrémités d'un chemin dans la cavité (10) allant de la source d'électrons (2) à l'orifice de sortie (11) afin de permettre le transport d'électrons à travers ladite cavité (10), lequel transport d'électrons est effectué via un processus d'émission secondaire, dans lequel pour chaque électron frappant la paroi, un électron en moyenne est émis.

2. Elément à décharge suivant la revendication 1, caractérisé en ce que la source d'électrons est placée dans la cavité.

3. Elément à décharge suivant la revendication 1, caractérisé en ce que la source d'électrons est placée à l'extérieur de la cavité et en ce que la cavité a un orifice d'entrée face à la source d'électrons.

4. Elément à décharge suivant la revendication 1, 2 ou 3, caractérisé en ce que la cavité a une configuration oblongue.

5. Elément à décharge suivant la revendication 4, caractérisé en ce que la surface émettant des électrons et la surface de l'orifice d'entrée sont sensiblement égales.

6. Elément à décharge suivant la revendication 1, 2 ou 3, caractérisé en ce que la surface de l'orifice de sortie est inférieure à la surface émettant des électrons.

7. Elément à décharge suivant la revendication 6, caractérisé en ce qu'en fonctionnement, la densité de courant d'un faisceau d'électrons quittant l'orifice de sortie est supérieure à la densité de courant d'un faisceau d'électrons émis par la source d'électrons.

8. Elément à décharge suivant la revendication 6, caractérisé en ce qu'en fonctionnement, la luminosité d'un faisceau d'électrons quittant l'orifice de sortie est supérieure à la luminosité d'un faisceau d'électrons émis par la source d'électrons.

9. Elément à décharge suivant la revendication 1, caractérisé en ce que la source d'électrons est pourvue de moyens pour la modulation du courant d'électrons à émettre.

10. Elément à décharge suivant la revendication 4, caractérisé en ce qu'au moins un orifice de sortie est prévu dans une paroi de cavité s'étendant longitudinalement.

11. Elément à décharge suivant la revendication 8, caractérisé en ce qu'une série d'orifices de sortie adjacents est prévue dans une paroi de cavité s'étendant longitudinalement.

12. Elément à décharge suivant la revendication 11, caractérisé en ce que des électrodes sont prévues à proximité des orifices de sortie, lesquelles électrodes peuvent être connectées à des moyens d'excitation pour les exciter en fonctionnement avec une tension requise pour l'ouverture ou la fermeture électriques des orifices.

13. Elément à décharge suivant la revendication 12, caractérisé en ce que les moyens d'excitation sont à même d'exciter séquentiellement les orifices de sortie.

14. Système d'adressage (49) à faisceaux d'électrons, caractérisé par une pluralité de cavités (56, 56', 56") de conduit électronique allongées, contiguës, chacune coopérant avec une source d'électrons (55), alors que des moyens à électrode connectables à une source de tension sont prévus pour appliquer, en fonctionnement, un champ électrique aux extrémités d'un chemin dans chaque cavité allant de la source d'électrons à un orifice de sortie afin de permettre le transport d'électrons à travers ladite cavité, lesquelles cavités sont définies par des parois (50, 51, 54) d'une matière isolante électrique ayant une résistance relativement élevée et un coefficient d'émission secondaire δ qui, pour un certain domaine d'énergies électroniques, est supérieur à 1, alors que des parois de cavité correspondantes s'étendant longitudinalement sont pourvues d'une série d'orifices (58, 58', 58") qui peuvent être commandés électriquement et constituent ensemble un agencement de matrice, le transport d'électrons étant effectué via un processus d'émission secondaire, dans lequel pour chaque électron frappant une paroi, un électron en moyenne est émis.

15. Système d'adressage suivant la revendication 14, caractérisé en ce que les sources d'électrons et les orifices peuvent être connectés à des moyens de commande pour réaliser, en fonctionnement, un balayage à séquence de lignes de l'agencement de matrice.

16. Tube analyseur comprenant un système d'adressage à faisceaux d'électrons suivant la revendication 14 ou 15.

17. Tube image comprenant un système d'adressage à faisceaux d'électrons suivant la revendication 14 ou 15.

18. Microscope électronique comprenant un élément à décharge électrique suivant l'une quelconque des revendications 1 à 10, à titre de source d'électrons.

19. Elément à décharge électrique suivant la revendication 1, caractérisé en ce que ladite source d'électrons (55) coopère avec un certain nombre de conduits électroniques à vide (56, 56', 56"), chacun étant défini par des parois (50, 51, 54) en une matière isolante électrique ayant une résistance relativement élevée et un coefficient d'émission secondaire δ qui, pour un certain domaine d'énergies électroniques, est supérieur à 1, et chaque conduit ayant un orifice de sortie, alors que des moyens à électrode connectables à une source de tensions sont prévus pour appliquer, en fonctionnement, un champ électrique aux extrémités d'un chemin dans chaque conduit allant de la source d'électrons à l'orifice de sortie de manière à permettre le transport d'électrons à travers ledit conduit.

20. Dispositif pour la gravure par faisceau d'électrons comprenant un élément à décharge électrique suivant la revendication 19, à titre de source d'électrons.

21. Dispositif suivant l'une quelconque des revendications précédentes, caractérisé en ce qu'en fonctionnement, le coefficient d'émission secondaire effectif $\delta_{eff}$ est approximativement égal à 1.

FIG.1

FIG.2

FIG.3

FIG.4

FIG.5

FIG.6

FIG.7

FIG.8

FIG.9

FIG.10

FIG.11A

FIG.11B

FIG.11C

FIG. 12